**Europäisches Patentamt**

**European Patent Office**

**Office européen des brevets**

(19)

(11) Veröffentlichungsnummer : **0 502 850 B1**

(12)

# EUROPÄISCHE PATENTSCHRIFT

(45) Veröffentlichungstag der Patentschrift :
**06.04.94 Patentblatt 94/14**

(51) Int. Cl.$^5$ : **G01R 33/54, G01R 33/46**

(21) Anmeldenummer : **90914701.9**

(22) Anmeldetag : **06.10.90**

(86) Internationale Anmeldenummer :
**PCT/EP90/01681**

(87) Internationale Veröffentlichungsnummer :
**WO 91/09322 27.06.91 Gazette 91/14**

(54) **HF-IMPULS-KASKADE ZUR ERZEUGUNG VON NMR-SPEKTREN.**

(30) Priorität : **08.12.89 DE 3940633**

(43) Veröffentlichungstag der Anmeldung :
**16.09.92 Patentblatt 92/38**

(45) Bekanntmachung des Hinweises auf die
Patenterteilung :
**06.04.94 Patentblatt 94/14**

(84) Benannte Vertragsstaaten :
**CH DE FR GB LI**

(56) Entgegenhaltungen :
**US-A- 4 682 106**
**US-A- 4 733 186**
**US-A- 4 757 260**
**US-A- 4 774 467**
**US-A- 4 818 940**
**US-A- 4 878 021**

(73) Patentinhaber : **SPECTROSPIN AG**
**Industriestrasse 26**
**CH-8117 Fällanden (CH)**

(72) Erfinder : **BODENHAUSEN, Geoffrey**
**11, chemin des Roches**
**CH-1009 Pully (CH)**
Erfinder : **EMSLEY, Lyndon**
**1, cheneau de Bourg**
**CH-1003 Lausanne (CH)**

(74) Vertreter : **KOHLER SCHMID + PARTNER**
**Patentanwälte Ruppmannstrasse 27**
**D-70565 Stuttgart (DE)**

EP 0 502 850 B1

**Beschreibung**

Die Erfindung betrifft ein Verfahren zum Erzeugen eines Spektrums von Kernspinresonanz-Signalen durch Einstrahlen einer Sequenz von n HF-Impulsen auf eine Probe, die sich in einem homogenen statischen Magnetfeld befindet, wobei die Einhüllende der Kernspinresonanz-Signalantwort im Frequenzraum näherungsweise eine Rechteckfunktion ist.

Die Fähigkeit zur Anregung oder Inversion von Kernspins über ein ausgewähltes Band von Frequenzen ist zu einem wichtigen Teil in vielen Experimenten in der modernen Kernspinresonanz geworden. In der hochauflösenden NMR-Spektroskopie ist es oft wünschenswert, die Breite der relevanten Frequenzdomäne zu beschränken, insbesondere in der zwei- und dreidimensionalen Spektroskopie. Frequenzselektive Anregung ist auch ein integraler Bestandteil einer ganzen Klasse von Experimenten, bei denen zwei- oder dreidimensionale Spektren in eine Dimension komprimiert werden. Die vielleicht wichtigste Anwendung der selektiven Anregung sind die NMR-Bildgebungsverfahren. In diesem Zusammenhang sind zwei besonders wichtige Probleme zu erwähnen, nämlich die Inversion über ein wohldefiniertes rechteckiges Fenster im Frequenzspektrum und die Anregung von transversaler Magnetisierung mit minimaler Phasendispersion ausgehend von longitudinaler Magnetisierung wiederum über ein rechteckiges Fenster im Frequenzspektrum.

Unter den zahlreichen Methoden, die von diversen Autoren für rechteckige Inversion und Anregung vorgeschlagen wurden, basiert eine Vielzahl auf der Anwendung von zusammengesetzten Impulsen, die aus Zügen von harten Impulsen bestehen, welche gegeneinander phasenversetzt sind, aber rechteckige Einhüllende und konstante Amplituden besitzen. Andere Verfahren zur rechteckigen Inversion und Anregung verwenden Amplituden- und/oder Phasen-Modulation. Im weiteren sollen nur Impulse mit rein amplituden-modulierten Einhüllenden betrachtet werden. Zur Spininversion kann man Hochfrequenz-(HF)-Impulse verwenden, deren Einhüllende durch einfache analytische Funktionen, wie z.B. Gauß-, Sinc- oder Hermite-Funktionen beschrieben werden können. Der einzige bekannte amplituden-modulierte Impuls zur phasenrichtigen Anregung mit einer Einhüllenden, die durch eine analytische Funktion beschrieben werden kann, ist ein Gauß-Impuls mit 270° on-resonance Flippwinkel. Obwohl mit diesem Impuls die obigen Probleme teilweise gelöst werden können, bleiben bei anspruchsvollen Anwendungen aufgrund der restlichen Phasendispersion und der mangelhaften Selektivität immer noch Probleme ungelöst.

Jüngste Anstrengungen zur Optimierung von geformten Impulsen basierten auf der Teilung einer willkürlichen Einhüllenden in der Zeit-Domäne in viele diskrete Intervalle und der Variation der HF-Amplitude in jedem einzelnen Intervall, bis die Signalantwort eine Zielfunktion gut approximiert. Zu diesem Zweck wurden verschiedene Grade an Verfeinerungen eingeführt, unter anderem die optimale Regeltechnik von Conolly et al. in "Proceedings of the Fourth Annual Meeting of the Society of Magnetic Resonance in Medicine, London, August 1985, S.958 ff", die konjugierte Gradientenmethode von Murdoch et al. in J. Magn. Reson. 74, 226 (1987) und die Linearisierung der Bloch-Gleichungen nach Ngo et al. in Magn. Reson. Med. 5, 217 (1987). Zwar führen diese Verfahren zu exzellenten Resultaten, wobei die von Ngo et al. ziemlich nahe an eine ideale Signalantwort heranreichen. Die sich ergebenden Einhüllenden benötigen jedoch zwischen 100 und 500 unabhängigen Parametern zu ihrer Definition, so daß ihre praktische Anwendung äußerst umständlich wird.

Aufgabe der vorliegenden Erfindung ist es daher, ein Verfahren nach dem Oberbegriff des Anspruchs 1 vorzustellen, bei dem durch eine Sequenz von n HF-Impulsen mit möglichst wenigen Anpassungsparametern ein Kernspinresonanz-Spektrum mit Rechteckcharakteristik im Frequenzraum erzeugt wird.

Die Aufgabe wird erfindungsgemäß dadurch gelöst, daß die n HF-Impulse der Sequenz amplituden-moduliert und ihre jeweiligen Amplitudenverteilungen annähernd der Form von Glockenkurven folgen, und daß vorab die Amplitudenverteilung der gesamten Impulssequenz in einer geeigneten Optimierungsprozedur unter dem Kriterium einer Minimierung der Abweichung der Einhüllenden der Kernspinresonanz-Signalantwort im Frequenzraum von einer Rechteckfunktion durch Variation von $3 \cdot n$ Parametern $w_k^{max}$, $t_k^{max}$, $a_k$ ermittelt worden ist, wobei $w_k^{max}$ die relative Amplitude des k-ten Impulses der Sequenz an der Position $t_k^{max}$ seines Extremums und $a_k$ die Breite des k-ten Impulses bedeuten.

Die Impulssequenz besteht aus einer Überlagerung wohlbekannter, einfach zu reproduzierender HF-Impulse, deren Anzahl n auf höchstens zehn begrenzt ist, was in jedem Falle für eine optimale Annäherung der Einhüllenden der Signalantwort an eine Rechteckfunktion ausreicht. Die Gesamtzahl der zu kontrollierenden freien Parameter überschreitet $3 \cdot n$ nicht.

Die Optimierung der erfindungsgemäßen Sequenz von glockenkurvenförmigen HF-Impulsen erfolgt vorab in an sich bekannter Weise durch Variation der die Glockenkurven charakterisierenden Parameter $w_k^{max}$, $t_k^{max}$ und $a_k$, die solange verändert werden, bis die Abweichung der Einhüllenden der Kernspinresonanz-Signalantwort im Frequenzraum von einer Rechteckfunktion minimal ist. Da die Optimierung lediglich einmal durchgeführt werden muß und sodann die optimalen Parameter für die Amplitudenverteilung $w_1(t)$ festliegen, spielt die Schnelligkeit der Optimierungsprozedur keine Rolle. Im Prinzip könnten die Parameter auch durch mehr oder minder qualifiziertes Erraten, durch Probieren oder durch eine "von Hand" durchgeführte einfache Iteration ermittelt werden.

Besonders einfach und bequem erfolgt die Minimierung der Abweichung der Einhüllenden der Kernspinresonanz-Signalantwort im Frequenzraum von einer Rechteckfunktion durch Anwendung eines numerischen Fitprogrammes auf einer automatischen Datenverarbeitungsanlage.

Bei einer vorteilhaften Ausbildung des erfindungsgemäßen Verfahrens erfolgt die Minimierung der Abweichung der Einhüllenden der Kernspinresonanz-Signalantwort im Frequenzraum von einer Rechteckfunktion durch Optimieren eines vorgegebenen Fehlerfunktionals, welches die Abweichung der Einhüllenden von einer Rechteckfunktion beschreibt. Die Optimierung kann abgebrochen werden, wenn das Fehlerfunktional einen vorgegebenen Grenzwert unterschreitet.

Die glockenkurvenförmigen HF-Impulse der Sequenz können allgemein auch leicht asymmetrisch sein. Bei einer speziellen Ausführungsform des erfindungsgemäßen Verfahrens enthält die Sequenz HF-Impulse, deren Amplitudenverteilung der Form einer Lorentz-Kurve folgt. Besonders bevorzugt ist eine Ausführungsform, bei der die Amplitudenverteilungen der HF-Impulse der Form von Gauß-Kurven folgen. Die unten erwähnten speziellen Parameterwerte wurden speziell für Gauß-Impuls-Kaskaden ermittelt und führten zu besonders guten Ergebnissen.

Bei einer besonderen Ausgestaltung des erfindungsgemäßen Verfahrens beträgt die Anzahl der HF-Impulse pro Sequenz n = 3. Damit ergibt sich eine Impulsfolge, die zur selektiven Inversion von kernmagnetischen Momenten besonders geeignet ist.

Die Einhüllende der Inversionssignalantwort kommt bei Anwendung des erfindungsgemäßen Verfahrens einer Rechteckfunktion besonders nahe, wenn die Parameter $w_k^{max}$, $t_k^{max}/t_p$ und $\Delta t_k^{1/2}/t_p$ jeweils einen entsprechenden Wert aus dem Intervall

$$1,2 < w_2^{max}/w_1^{max} < 1,5; \ 0,3 < w_3^{max}/w_1^{max} < 0,7$$
$$15 < \Delta t_1^{1/2}/t_p < 25; \ 15 < \Delta t_2^{1/2}/t_p < 25; \ 20 < \Delta t_3^{1/2}/t_p < 30;$$
$$20 < t_1^{max}/t_p < 40; \ 40 < t_2^{max}/t_p < 60; \ 70 < t_3^{max}/t_p < 90$$

annehmen, wobei $\Delta t_k^{1/2}$ die halbe Impulsbreite des k-ten Impulses bei der halben Impulsamplitude $w_k^{max}/2$ und $a_k = \ln 2/(\Delta t_k^{1/2})^2$ ist, insbesondere, wenn die Parameter jeweils den Wert

$$w_1^{max} = -1,00 \ ; \ w_2^{max} = 1,37 \ ; \ w_3^{max} = 0,49;$$
$$\Delta t_1^{1/2}/t_p = 18,9; \ \Delta t_2^{1/2}/t_p = 18,3; \ \Delta t_3^{1/2}/t_p = 24,3;$$
$$t_1^{max}/t_p = 28,7; \ t_2^{max}/t_p = 50,8; \ t_3^{max}/t_p = 79,5$$

annehmen.

Bei Verwendung von n = 4 HF-Impulsen in der Impulssequenz $w_1$ (t) ist das erfindungsgemäße Verfahren besonders gut für die phasenrichtige Anregung von transversaler Magnetisierung geeignet. Ein besonders gutes Ergebnis wird erzielt, wenn die Parameter $w_k^{max}$, $t_k^{max}/t_p$ und $\Delta t_k^{1/2}/t_p$ jeweils einen entsprechenden Wert aus dem Intervall

$$0,95 < w_2^{max}/w_1^{max} < 1,35; \ -1,7 < w_3^{max}/w_1^{max} < -1,3; \ -0,7 < w_4^{max}/w_1^{max} < -0,4;$$
$$15 < \Delta t_1^{1/2}/t_p < 20; \ 10 < \Delta t_2^{1/2}/t_p < 15; \ 10 < \Delta t_3^{1/2}/t_p < 15; \ 10 < \Delta t_4^{1/2}/t_p < 20;$$
$$5 < t_1^{max}/t_p < 25; \ 40 < t_2^{max}/t_p < 60; \ 55 < t_3^{max}/t_p < 75; \ 75 < t_4^{max}/t_p < 95$$

annehmen, insbesondere die Werte

$$w_1^{max} = 0,62 \ ; \ w_2^{max} = 0,72 \ ; \ w_3^{max} = -0,91; \ w_4^{max} = -0,33;$$
$$\Delta t_1^{1/2}/t_p = 17,2; \ \Delta t_2^{1/2}/t_p = 12,9; \ \Delta t_3^{1/2}/t_p = 11,9; \ \Delta t_4^{1/2}/t_p = 13,9;$$
$$t_1^{max}/t_p = 17,7; \ t_2^{max}/t_p = 49,2; \ t_3^{max}/t_p = 65,3; \ t_4^{max}/t_p = 89,2.$$

Besonders vorteilhaft ist die Verwendung des erfindungsgemäßen Verfahrens als Bestandteil von bildgebenden Verfahren, insbesondere in der NMR-Tomographie, bei der mehrdimensionalen NMR-Spektroskopie und insbesondere zur volumenselektiven NMR-Spektroskopie. Die erfindungsgemäße Sequenz von n HF-Impulsen kann Teil einer NOESY-Impulsfolge oder Teil einer COSY-Impulsfolge sein.

Die Erfindung betrifft auch ein NMR-Spektrometer nach dem Oberbegriff des Anspruchs 18, dessen Speicher einen Datensatz zur Erzeugung einer Sequenz von HF-Impulsen gemäß dem kennzeichnenden Teil von Anspruch 1 enthält. Ein solches Spektrometer kann so weitergebildet sein, daß die oben beschriebenen Ausgestaltungen des erfindungsgemäßen Verfahrens darauf ausgeführt werden können.

Die Erfindung wird im folgenden anhand der in der Zeichnung dargestellten Ausführungsbeispiele näher beschrieben und erläutert. Die der Beschreibung, den Tabellen und der Zeichnung zu entnehmenden Merkmale können bei anderen Ausführungsformen der Erfindung einzeln für sich oder zu mehreren in beliebiger Kombination Anwendung finden. Es zeigen:

Fig. 1     Fourier-Transformierte (gestrichelt) zusammen mit der numerisch berechneten transversalen Magnetisierung <Mxy> (durchgezogene Linie) von Gauß-Impuls-Kaskaden, deren drei Einzelimpulse die nominalen Flippwinkel +45°, -90°, + 135° ergeben, wobei

a) jeder Einzelimpuls eine dem Flippwinkel proportionale Breite besitzt, bzw.

b) die Einzelimpulse gleiche Breiten und zum Flippwinkel proportionale Amplituden besitzen,

Fig. 2      einen Vergleich der $M_z$-Antworten von Inversions-Impulsen, deren Einhüllende

    a) ein einzelner Gauß-Impuls,

    b) ein Sinc-Impuls und

    c) eine erfindungsgemäße Gauß-Impuls-Kaskade mit n = 3,

Fig. 3      die $M_z$-Antworten auf eine erfindungsgemäße Inversions-Impuls-Kaskade ausgehend von einer Start-Funktion (a), sowie nach verschiedenen Optimierungszyklen (b), (c), (d),

Fig. 4

    a) die Startfunktion mit n = 4 und die entsprechenden $M_x$- und $M_y$-Profile nach einer phasenrichtigen Anregung,

    b) die optimierte Anregungs-Kaskade und die entsprechenden optimierten Signale,

Fig. 5

    a) das experimentelle Ergebnis einer Inversions-Kaskade n = 3 (oben), sowie das Ergebnis einer Simulation dieses Experiments (unten) und

    b) das experimentelle Ergebnis einer Anregungs-Kaskade n = 4 (oben), sowie die entsprechende Simulationsrechnung (unten), und

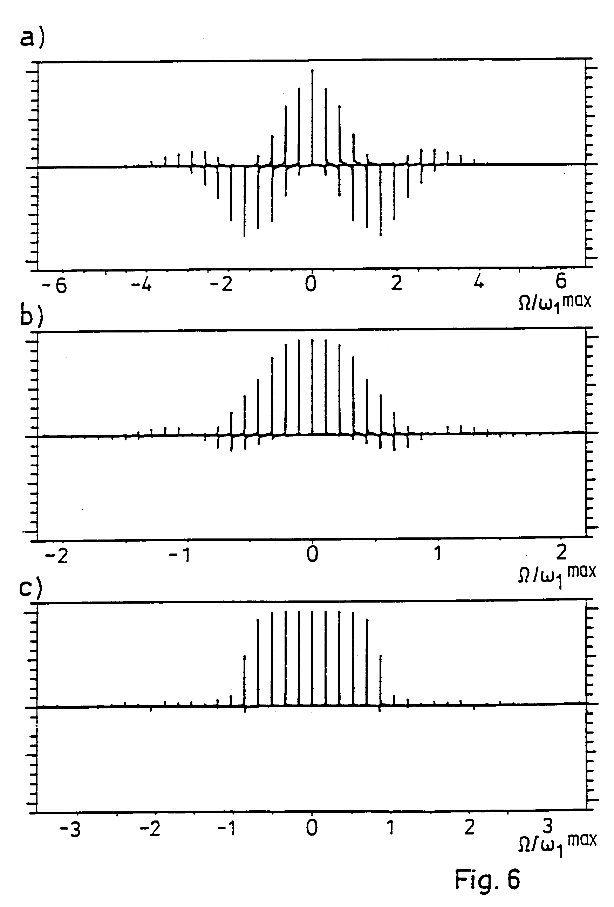

Fig. 6      einen Vergleich des simulierten Verhaltens

    a) eines 90° Gauß-Impulses,

    b) eines 270° Gauß-Impulses und

    c) einer erfindungsgemäßen Anregungs-Impuls-Kaskade (n = 4).

Für kleine Flippwinkel entspricht die Frequenzantwort des Spinsystems ungefähr der Fouriertransformierten der Einhüllenden des Impulses in der Zeitdomäne. Weit außerhalb der Resonanz, wo die Magnetisierungstrajektorien im wesentlichen auf schmale Auslenkungen in der Nachbarschaft des "Nordpoles" des Bezugssystemes beschränkt sind, wurde gezeigt, daß die obige Äquivalenz sogar für große effektive Flippwinkel erhalten bleibt. Für die Vorhersage des on-resonance-Verhaltens bei großen Flippwinkeln, wie sie für Inversion, Refokussierung oder sogar für effiziente Anregung der transversalen Magnetisierung erforderlich sind, bricht die Äquivalenz jedoch vollständig zusammen. Obwohl also Impulse mit Gauß- oder sinc-Einhüllenden nützliche Eigenschaften besitzen, können diese nicht der Tatsache zugeschrieben werden, daß die Fouriertransformierten dieser Einhüllenden die Form von Gauß- und Rechteckfunktionen im Frequenzraum besitzen.

Im folgenden wird eine neue Klasse von amplituden-modulierten Impulsen vorgestellt, die insbesondere sowohl für die selektive Inversion als auch für phasenrichtige Anregung nützlich sind, und die von analytischen der Form

$$\omega_I(t) = \sum_{k=1}^{n} \left[ \omega_k^{max} \exp\{-a_k(t-t_k^{max})^2\} \right] \ \Pi(0, t_p). \qquad [1]$$

beschrieben werden. Diese Funktion repräsentiert eine Einhüllende der zeitlichen Dauer $t_p$ und besteht aus einer Superposition von n Gauß-Funktionen, wobei für die k-te Gauß-Funktion die Position des Extremums durch $t_k^{max}$, die Peak-Amplitude durch $W_k^{max}$ und die Breite durch

$$a_k = \ln2/(\Delta t^{1/2}{}_k)^2$$

gegeben ist und $\Delta t_k^{1/2}$ die halbe Impulsbreite des k-ten Impulses bei der halben Impulsamplitude bedeutet. Die Funktion $n(0,t_p)$ stellt eine Kastenfunktion mit dem Wert 1 zwischen t = 0 und $t_p$ und dem Wert 0 überall sonst dar.

Da die Fourier-Äquivalenz für große Frequenzverschiebungen von der Resonanz gilt ($\Omega/W_1^{max} > 1$), muß die Fourier-Transformierte einer idealen Impulskaskade außerhalb der relevanten Bandbreite so nah wie möglich bei 0 liegen. Abrupte Variationen der Amplitude sollten daher vermieden werden, weil sie zu erratischen Fourier-Transformierten führen. Daher wurden die Impulsformen der Einzelimpulse in der Kaskade als Gauß-Funktionen im Gegensatz zu den sonst üblichen rechteckigen Einhüllenden gewählt. Außerdem wird die Form der Fourier-Transformierten eines Impulses nicht durch die Amplitude, sondern lediglich durch seine Breite beeinflußt. Als direkte Konsequenz der Additions- und Verschiebungstheoreme läßt sich zeigen, daß eine Kaskade von n verschobenen Gauß-Impulsen mit identischen Breiten ($a_k = a$ für alle k) und variablen Amplituden eine Fourier-Transformierte besitzt, die aus einer Summe von n Gauß-Einhüllenden mit identischen Breiten (und variablen Amplituden) besteht:

$$s(t) = \sum_{k=1}^{n} \omega_k^{max} \exp\{-a(t-t_k^{max})^2\}$$

$$\Rightarrow \quad S(\Omega) = \sum_{k=1}^{n} (\pi/a)^{1/2} \omega_k^{max} \exp\{-it_k^{max}\Omega\} \exp\{-\Omega^2/(4a)\} \ . \quad (2)$$

Die Gauß-Impulse im Frequenzraum werden daher lediglich frequenzabhängigen Phasen zugeordnet sein, die die Zeitverschiebungen in der Kaskade reflektieren. Daraus kann man ersehen, daß die Ausgangssequenz für eine Gauß-Kaskade Einzelimpulse mit gleichen Breiten $a_k$ und Amplituden $\Omega_k^{max}$ besitzen sollte, die gemäß den gewünschten nominalen Flippwinkeln variieren. Auf diese Weise kann man erwarten, daß die Anregung so schnell abfällt wie die eines einzelnen Gauß-Impulses.

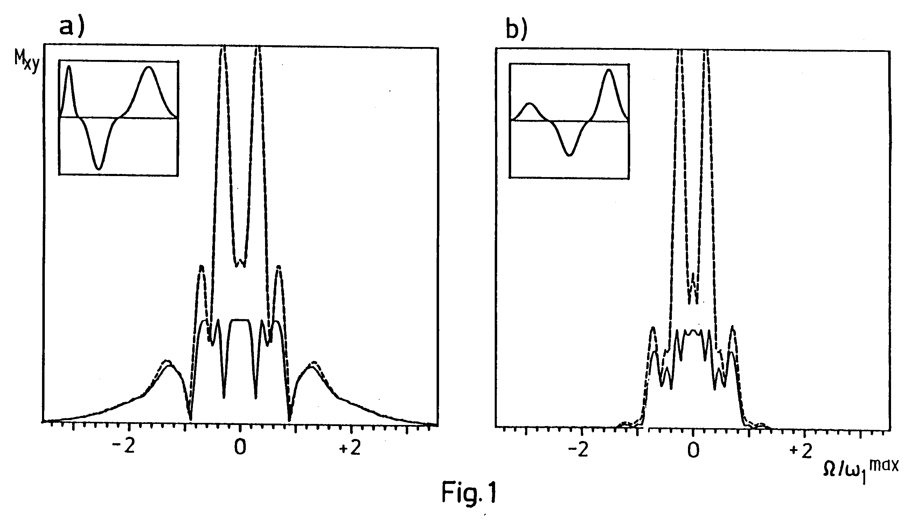

Zur Demonstration dieses Argumentes zeigt Fig. 1 die Fourier-Transformierten zusammen mit numerischen Simulationen der $<M_{xy}>$-Antworten auf zwei Gauß-Impuls-Kaskaden, deren Einzelimpulse jeweils nominale on-resonance-Flippwinkel von +45°, -90° und +135° besitzen. Falls die Amplituden konstant und die Breiten proportional zu den Flippwinkeln sind, ist es offensichtlich, daß die Schwänze der Anregungsprofile sehr langsam auf Null gehen. Im Gegensatz dazu führt eine Kaskade von Gauß-Impulsen mit gleichen Impulsbreiten, aber zu den Flippwinkeln proportionalen Amplituden zu einer Antwort, die sehr viel rascher abklingt. Man beachte auch, daß die Fourier-Transformierte nicht direkt das on-resonance-Verhalten vorhersagt. Obwohl das Prinzip der Amplitudenmodulation im Gegensatz zur Modulation der Impulsdauer leicht auf Impulskaskaden mit beliebiger Phasenverschiebung ausgeweitet werden kann, sollen im Moment lediglich Impulszüge mit konstanter Phase berücksichtigt werden, wobei allerdings Phasenumkehr (z.B. von x nach -x) erlaubt sein soll. Die Impulsantworten in Fig. 1 sind als Funktion der normierten Frequenzverschiebung $\Omega/w_1^{max}$ dargestellt, wobei $\Omega = W_0 - W_{HF}$ und $w_1^{max}$ die Frequenzverschiebung und die maximale HF-Amplitude des 90°-Impulses sind.

Die Impulse wurden auf dem Computer mit einer modifizierten Simplex-Prozedur optimiert, wobei die Abweichung von einer rechteckigen Zielfunktion minimiert wurde. Man beachte, daß die obengenannten Fourier-Bedingungen hinreichend für das gewünschte off-resonance-Verhalten, jedoch keineswegs notwendig sind. Es kann gut sein, daß Kaskaden mit ungleichen Impulsbreiten $a_k$ ebenfalls zu gutartigen Antwortsignalen führen. Daher wurde die Optimierung mit allen unabhängigen Parametern von Gl. (1) ausgeführt. Die Minimierung des Fehlers einer Impuls-Antwort, die den Bloch-Gleichungen genügt, wird durch die Anwesenheit einer Vielzahl von flachen Schein-Minima besonders erschwert. Dieses Problem wird am einfachsten durch Redefinition der Form des Fehlerfunktionals während der Optimierungsprozedur gelöst.

Als Startwert für eine Impulskaskade mit drei Impulsen wurde die folgende Sequenz gewählt:

$$G\{270°_{-x}\} \ G\{270°_x\} \ G\{180°_x\} \quad [3]$$

Die Sequenz besteht aus einem einfachen Vorbereitungszyklus, dem ein gewöhnlicher Inversions-Impuls folgt. Der $G\{270°_{-x}\} \ G\{270°_x\}$-Zyklus hat keinen Netto-Effekt in der Gegend der Resonanz, sondern präpariert die off-resonance-Magnetisierung in günstiger Weise für die nachfolgende Einwirkung des 180°-Impulses zur Erzeugung eines rechteckigen Inversionsprofiles. Im Hinblick auf die Überlegungen bezüglich der Fourier-Transformierten wurden alle drei Gauß-Impulse mit der gleichen Breite aber mit zu den Flippwinkel proportionalen Amplituden gewählt.

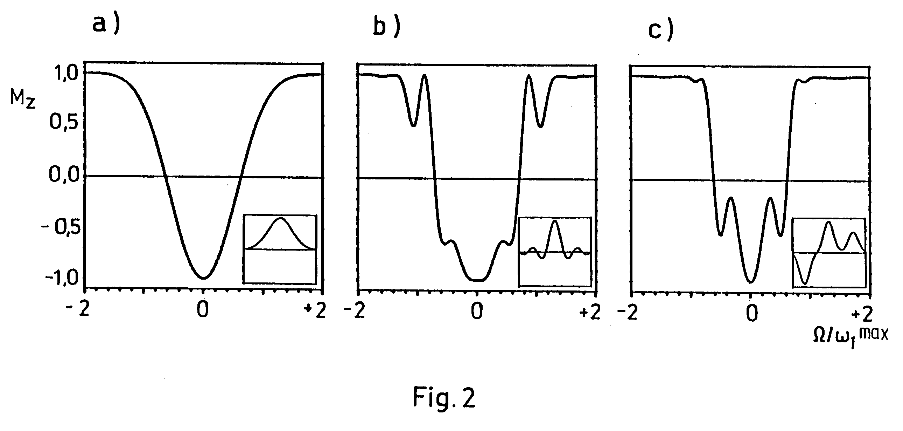

In Fig. 2 wird die $M_z$-Magnetisierung als Funktion der normierten Frequenzverschiebung nach Anwendung (a) eines 180°-Gauß-Impulses, (b) eines 180°-Sinc-Impulses und (c) der Kaskade nach Gl. [3] verglichen. Der Gauß-Impuls wurde bei 5% von $w_1^{max}$ abgeschnitten, der Sinc-Impuls hatte vier Nulldurchquerungen auf jeder Seite des Maximums und die Kaskade besaß die Parameter aus Zyklus 0 in Tab. 1. Obwohl das Ergebnis der Kaskade von Fig. 2c innerhalb der gewählten Bandbreite alles andere als perfekt ist, zeigt die fehlende Anregung außerhalb der gewünschten Bandbreite eine Verbesserung gegenüber dem einzelnen Gauß-Impuls und der Sinc-Funktion. Die Sequenz $G\{270°_{-x}\} \ G\{270°_x\} \ G\{180°_x\}$ wurde daher als Startpunkt für eine Optimierung benutzt.

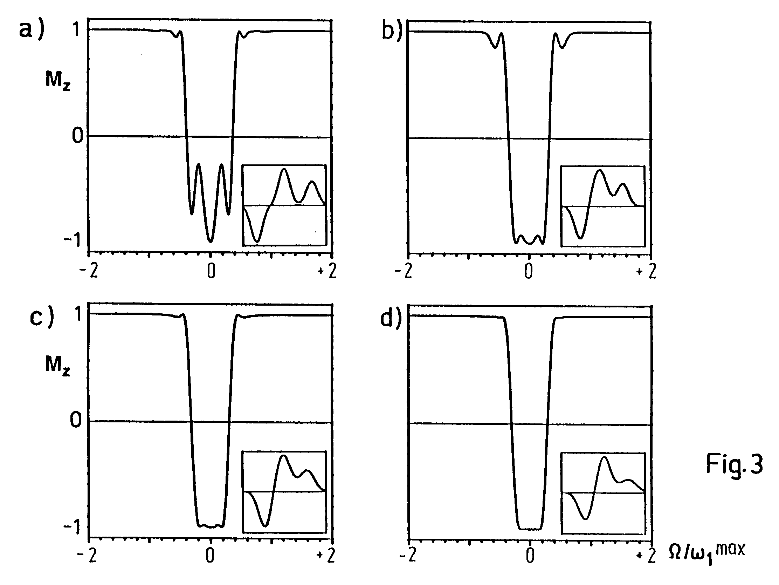

Fig. 3a bis d zeigt die $M_z$-Magnetisierungsprofile nach sukzessiven Zyklen in der Optimierungsprozedur. Dabei ist (a) die Startfunktion, (b), (c) und (d) sind die Ergebnisse des ersten, zweiten und dritten Optimierungszyklus, wobei letzteres die endgültig angenommene Inversions-Kaskade $G^3$ ist. Die Parameter für die resultierenden Impulse sind in Tab. 1 aufgeführt. Für jeden Optimierungszyklus (150 Iterationen) werden zwei Fehlerfunktionen $f^{in}$ und $f^{out}$ definiert, eine für die Isochromaten innerhalb und eine für die Isochromaten außerhalb des Anregungs- bzw. Inversions-Rechteckes:

$$\Delta^{in} \;=\; \sum_{k<(l-m)} f^{in}(\mathbf{M}_k) \qquad\qquad [4]$$

$$\Delta^{out} \;=\; \sum_{k>(l+m')} f^{out}(\mathbf{M}_k) \qquad\qquad [5]$$

Dabei ist $M_k$ die Magnetisierungsantwort für $t = t_p$ bei der k-ten Verschiebung und 1 der Punkt, an dem die $M_z$-Antwort durch 0 läuft (nur für Inversion). Die Intervalle m und m' korrespondieren zu einer kleinen Übergangszone, in der sich die Antwort frei bewegen darf, ohne zum Fehlerfunktional beizutragen. Die Fehlerfunktionale sind definiert als

$$f_{inv}^{out}(\mathbf{M}_k) = f_{exc}^{out}(\mathbf{M}_k) = (M_{kx}^{2} + M_{ky}^{2})^{a} \qquad\qquad [6]$$

$$f_{inv}^{in}(\mathbf{M}_k) = b(1 + M_{kz}) \qquad\qquad [7]$$

$$f_{exc}^{in}(\mathbf{M}_k) = c[(1 - M_{kx})^{2} + dM_{ky}^{2}]^{g} + h(M_{kz}^{2} + M_{ky}^{2}) \qquad\qquad [8]$$

wobei sich die Subskripte inv und exc auf Funktionen beziehen, die zur Optimierung von Inversions- bzw. Anregungsimpulsen verwendet werden. Die Parameter a-h, die die Fehlerfunktionale nach Gl. (6) bis (8) definieren, können von Zyklus zu Zyklus während der Optimierung verändert werden und sind in Tab. 1 und 2 zusammen mit den Werten m und m' sowie den Parametern für jeden einzelnen Puls in der Kaskade angegeben, wobei letztere Parameter in Form der Position $t_k^{max}$ des kten Impulses in Einheiten der zeitlichen Dauer $t_p$ der Sequenz, der relativen Amplitude $w_k^{max}$ und der Linienbreite $\Delta t_k^{1/2}$ ebenfalls in Einheiten von $t_p$ dargestellt sind. Man beachte, daß jeweils entweder c oder h in Gl. [8] Null ist. Die Optimierung wurde für 80 Isochromaten ausgeführt und jede Antwort durch numerische Lösung der Bloch-Gleichungen mit 200 gleichen Zeitintervallen in der Integration berechnet. Die Frequenzverschiebungen sind so gewählt, daß 1 etwa bei der 25. Isochromate liegt, und die Fehlerfunktion ist normiert, um irgendwelche Variationen in 1 von Iteration zu Iteration zu berücksichtigen. Jeder Optimierungszyklus besteht aus 150 Iterationen einer Simplex-Minimierung der Fehlerfunktion. In Fig. 3a bis d sind auch die Impulsformen gezeigt, die sich nach jedem Zyklus ergeben, so daß es möglich ist, die graduelle Optimierung des Impulses sichtbar zu machen. Der letzte Inversions-Impuls, der $G^3$ genannt wird, besitzt die in Tab. 1 angegebenen Parameter und ist dem Anfangswert bei Zyklus 0 ziemlich ähnlich. Zum Erhalt des vorliegenden Resultates wurden lediglich drei Zyklen der Optimierungsprozedur benötigt, die ungefähr 15 Minuten c.p.u.-Zeit auf einem VAX 8550-Verbund bei 14 mips benötigten.

Die $G^3$-Kaskade kann nicht nur für die Inversion, sondern auch als refokussierender Impuls benutzt werden. Obwohl der Impuls nicht für diesen Zweck optimiert wurde, verhält er sich dennoch auch in dieser Hinsicht vorteilhaft. Diese Eigenschaft wird im folgenden für den Aufbau von Anregungs-Impulsen benutzt.

Ein weiteres Ziel ist es, einen Impuls zu finden, der in einem ausgewählten Frequenzintervall die longitudinale Magnetisierung in transversale Magnetisierung mit der geringstmöglichen Phasendispersion überführen kann. Außerhalb des gewählten Intervalles sollte der Ausgangszustand sowenig wie möglich gestört werden. Diese Anforderungen können im Ausdruck "rechteckige phasenrichtige Anregung" zusammengefaßt werden. Bisher wurde noch keine geeignete Impuls-Kaskade mit nur drei Gauß-Impulsen für diesen Zweck gefunden. Die einfachste vier-Impuls-Kaskade ist ein gewöhnlicher 270°-Gauß-Anregungs-Impuls, dem eine $G^3$-Kaskade als refokussierender Impuls folgt.

$$G\{270°_x\}G^3_x \quad [9]$$

Diese Kaskade wurde als Startwert benutzt. Die Phase einer Kaskade soll im folgenden durch ein Subskript angezeigt werden, das die Phase des ersten Einzelimpulses repräsentiert. Der gesamte on-resonance-Flippwinkel der Sequenz in Gl. [9] ist daher +90°. Der Verlauf der Optimierung ist in Tab. 2 gezeigt. Da Anregung von Natur aus ein schwierigeres Problem darstellt, konvergierte die Optimierung langsamer und bedurfte 11 Zyklen und etwa 90 Minuten c.p.u.-Zeit.

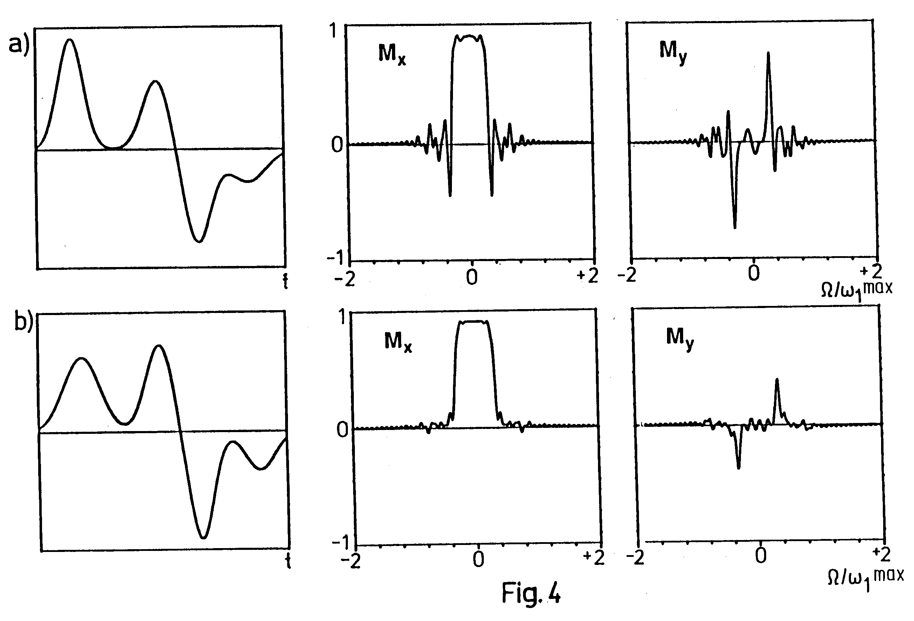

Fig. 4 zeigt die Antworten auf den Startimpuls (a) und auf den Endimpuls (b), wie er durch die Optimierung erzeugt wurde. Letzterer wird im folgenden $G^4$ genannt. Wenn man als nutzbare Bandbreite den Bereich definiert, in dem die Amplitude $M_{xy}$ 90% des Maximalwertes überschreitet, beträgt die maximale Phasenabweichung des $G^4$-Impulses in diesem Fenster weniger als 5°.

Experimente mit Gauß-Impuls-Kaskaden wurden auf einem Bruker AM-400-Spektrometer durchgeführt, das mit einer Einrichtung zur selektiven Anregung von Oxford Research Systems (Serie Nr. H1657/0013) bestückt war. Die Impulsformen wurden von einem Pascal-Programm generiert, das auf dem Aspect 3000 Computer läuft, das eine Datei erzeugt, die von dem Bruker SHAPE-PACKAGE benutzt werden kann, um die Daten für den Wellenform-Speicher zu kreieren. Die Generierung der einhüllenden Funktionen im Falle der Inversion bzw. Anregung reduziert sich dabei auf das schlichte Eingeben der neun bzw. zwölf relevanten Parameter, die jeweils am Ende von Tab. 1 bzw. 2 angegeben sind.

Die in den Fig. 1 bis 3 eingesetzten Kästchen sowie die beiden linken Kästchen in Fig. 4 zeigen die Einhüllende der jeweils verwendeten Gauß-Impuls-Kaskade.

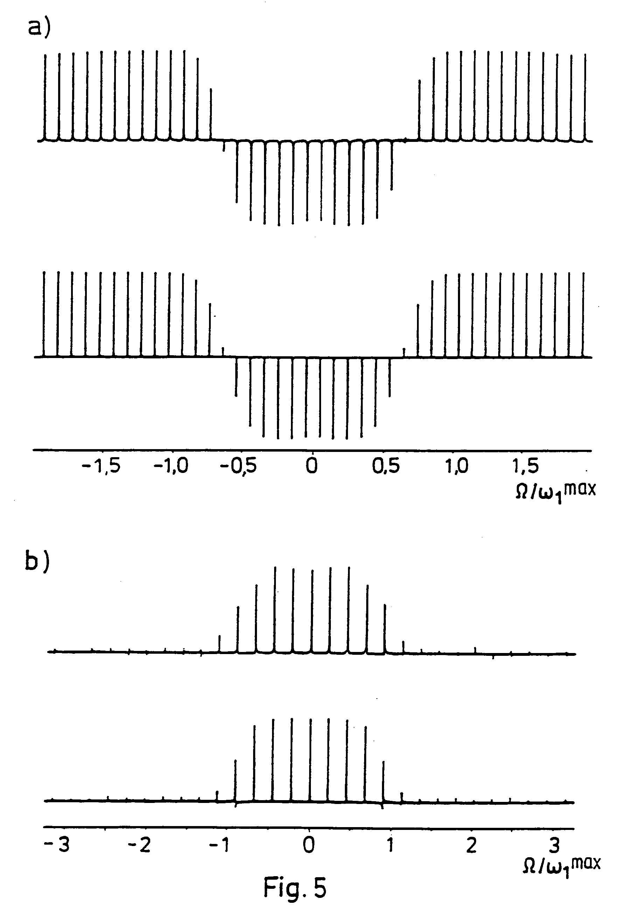

Fig. 5a zeigt das experimentelle Verhalten der $G^3$-Kaskade. Die Ergebnisse wurden durch Anlegen der Sequenz

$$G^3_\Phi - 90° - \text{acquisition} \quad [10]$$

erhalten, wobei der 90°-Impuls ein gewöhnlicher harter nichtselektiver Impuls ist. Die Position der Proton-Resonanz von Benzen (dotiert mit $Cr(acac)_3$) wurde durch schrittweises Inkrementieren der Senderfrequenz verändert. Die Phase der $G^3$-Kaskade wurde durch $\Phi$ = 0°, 90°, 180° und 270° gedreht, während die Empfängerphase konstant gehalten wurde, um sicherzustellen, daß nur die Z-Komponente der durch die $G^3$-Kaskade erzeugten Magnetisierung gemessen wurde. Die Übereinstimmung mit der Theorie ist exzellent. Im oberen Bild ist das tatsächliche experimentelle Ergebnis gezeigt, während das untere Bild von Fig. 5a die Simulation dieses Experimentes zeigt. Die unvollständige Inversion im Zentrum ist ein Ausdruck der HF-Inhomogenität in der Probe, die durch eine Lorentzverteilung der Flippwinkel mit einer Halbwertsbreite von $w_1 = 0,12 \cdot w_1^{nominal}$ repräsentiert wird. Die HF-Inhomogenität hat lediglich einen geringen Effekt auf die resultierenden Profile, welcher von der Theorie ebenfalls vorhergesagt wird.

Fig. 5b zeigt einen ähnlichen Satz von Ergebnissen für die $G^4$-Anregungs-Kaskade. Diese wurden durch den Einsatz einer einfachen $G^4$-acquisition-Sequenz und schrittweises Inkrementieren der Frequenz des Senders wie oben beschrieben erhalten. Wiederum ist die Übereinstimmung von Theorie und Experiment nahezu exakt. Es wurde keine frequenz-abhängige Phasenkorrektur an diesen Spektren vorgenommen. Man beachte, daß die Impulsantwort eine konstante Phase bis hin zur Grenze der Anregungsbandbreite besitzt.

Zum Vergleich zeigt Fig. 6 das simulierte Verhalten (a) eines einzelnen 90°-Gauß-Impulses (b) eines 270°-Gauß-Impulses und (c) der $G^4$-Anregungs-Kaskade. Man sieht, daß die Kaskade eine beträchtliche Verbesserung sowohl für das Profil selbst als auch für die Phaseneigenschaften der Impuls-Antwort darstellt.

Das erfindungsgemäße Verfahren, insbesondere die Anwendung der $G^3$-Inversions-Kaskade und der $G^4$-Anregungs-Kaskade kann auch als Teil von bilderzeugenden Verfahren in der NMR-Tomographie verwendet werden. Da die erfindungsgemäßen Impulssequenzen experimentell leicht generiert werden können, ist auch ihre Verwendung in der mehrdimensionalen NMR-Spektroskopie, insbesondere in der volumenselektiven NMR-Spektroskopie vorteilhaft. Die erfindungsgemäße Sequenz von n HF-Impulsen kann speziell auch Teil einer Impulsfolge zur korrelierten NMR-Spektroskopie (COSY) oder einer NOESY-Impulsfolge sein.

Allgemein können anstelle der oben ausführlich diskutierten Gauß-Impulse auch andere HF-Impulse mit im wesentlichen glockenkurvenförmiger Amplitudenverteilung, die sogar leicht asymmetrisch sein kann, als Bestandteile der erfindungsgemäßen HF-Impuls-Sequenz Anwendung finden. Eine solche Glockenkurvenform wird z.B. auch durch die bekannte Lorentz-Funktion beschrieben:

$$S_k(t) = w_k^{max}/\pi \cdot a_k/[a_k^2 + (t - t_k^{max})^2]$$

Tab. 1

| | | Fehlerfunktion | | | | Impuls Nr. (k) | | |
|---|---|---|---|---|---|---|---|---|
| Zyklus | m | m' | a | b | | 1 | 2 | 3 |
| 0 | | | | | $t_k{}^{max}/t_p$ | 16.6 | 50.0 | 83.3 |
| | | | | | $w_k{}^{max}$ | −1.00 | 1.00 | 0.66 |
| | | | | | $\Delta t_k{}^{1/2}/t_p$ | 16.0 | 16.0 | 16.0 |
| 1 | 2 | 2 | 1/2 | 15 | $t_k{}^{max}/t_p$ | 23.3 | 45.8 | 73.8 |
| | | | | | $w_k{}^{max}$ | −1.00 | 1.10 | 0.68 |
| | | | | | $\Delta t_k{}^{1/2}/t_p$ | 16.8 | 20.4 | 15.7 |
| 2 | 2 | 2 | 1/2 | 5 | $t_k{}^{max}/t_p$ | 27.5 | 48.6 | 77.3 |
| | | | | | $w_k{}^{max}$ | −1.00 | 1.04 | 0.59 |
| | | | | | $\Delta t_k{}^{1/2}/t_p$ | 18.6 | 20.9 | 20.0 |
| 3 | 2 | 2 | 1/2 | 15 | $t_k{}^{max}/t_p$ | 28.7 | 50.8 | 79.5 |
| | | | | | $w_k{}^{max}$ | −1.00 | 1.37 | 0.49 |
| | | | | | $\Delta t_k{}^{1/2}/t_p$ | 18.9 | 18.3 | 24.3 |

Tab.2

| | | Fehlerfunktion | | | | | | | | Impuls-Nr.(k) | | | |
|---|---|---|---|---|---|---|---|---|---|---|---|---|---|
| Zyklus | m | m' | a | c | d | g | h | | 1 | 2 | 3 | 4 |
| 0 | | | | | | | | $t_k^{max}/t_p$ | 14.2 | 49.1 | 64.9 | 85.3 |
| | | | | | | | | $w_k^{max}$ | 1.00 | 0.64 | -0.87 | -0.31 |
| | | | | | | | | $\Delta t_k^{1/2}/t_p$ | 12.2 | 13.5 | 13.1 | 17.42 |
| 1 | 2 | 2 | 1 | 0 | 0 | 0 | 3 | $t_k^{max}/t_p$ | 13.4 | 49.9 | 64.7 | 85.2 |
| | | | | | | | | $w_k^{max}$ | 0.97 | 0.65 | -0.86 | -0.35 |
| | | | | | | | | $\Delta t_k^{1/2}/t_p$ | 12.1 | 14.1 | 12.6 | 15.7 |
| 2 | 2 | 2 | 1 | 0 | 0 | 0 | 6 | $k^{max}/t_p$ | 13.2 | 49.8 | 64.3 | 85.0 |
| | | | | | | | | $w_k^{max}$ | 0.93 | 0.67 | -0.92 | -0.33 |
| | | | | | | | | $\Delta t_k^{1/2}/t_p$ | 12.7 | 14.1 | 12.3 | 15.7 |
| 3 | 4 | 2 | 1 | 1 | 6 | 1 | 0 | $t_k^{max}/t_p$ | 13.5 | 50.2 | 65.0 | 85.0 |
| | | | | | | | | $w_k^{max}$ | 0.97 | 0.75 | -0.97 | -0.36 |
| | | | | | | | | $\Delta t_k^{1/2}/t_p$ | 12.9 | 13.2 | 12.2 | 15.6 |
| 4 | 3 | 2 | 1 | 1 | 6 | 1 | 0 | $t_k^{max}/t_p$ | 18.1 | 50.2 | 65.6 | 87.5 |
| | | | | | | | | $w_k^{max}$ | 0.81 | 0.71 | -1.02 | -0.30 |
| | | | | | | | | $\Delta t_k^{1/2}/t_p$ | 13.6 | 13.1 | 10.9 | 14.1 |

| | | | | | | | | | | | | |
|---|---|---|---|---|---|---|---|---|---|---|---|---|
| 5 | 2 | 2 | 1 | 1 | 6 | 1 | 0 | $t_k^{max}/t_p$ | 18.7 | 50.7 | 66.1 | 87.7 |
| | | | | | | | | $w_k^{max}$ | 0.76 | 0.75 | -0.99 | -0.36 |
| | | | | | | | | $\Delta t_k^{1/2}/t_p$ | 14.6 | 14.1 | 12.0 | 13.7 |
| 6 | 1 | 1 | 1 | 1 | 6 | 1 | 0 | $t_k^{max}/t_p$ | 16.5 | 49.4 | 65.3 | 89.3 |
| | | | | | | | | $w_k^{max}$ | 0.70 | 0.72 | -0.95 | -0.37 |
| | | | | | | | | $\Delta t_k^{1/2}/t_p$ | 16.3 | 15.1 | 13.2 | 14.5 |
| 7 | 1 | 1 | 1/2 | 1 | 6 | 1/2 | 0 | $t_k^{max}/t_p$ | 16.7 | 49.2 | 65.2 | 89.8 |
| | | | | | | | | $w_k^{max}$ | 0.63 | 0.74 | -0.91 | -0.35 |
| | | | | | | | | $\Delta t_k^{1/2}/t_p$ | 17.4 | 14.0 | 13.1 | 14.7 |
| 8 | 1 | 1 | 1/2 | 1 | 3 | 1/2 | 0 | $t_k^{max}/t_p$ | 17.6 | 49.3 | 65.4 | 89.7 |
| | | | | | | | | $w_k^{max}$ | 0.63 | 0.75 | -0.89 | -0.35 |
| | | | | | | | | $\Delta t_k^{1/2}/t_p$ | 17.7 | 13.7 | 13.1 | 14.7 |
| 9 | 1 | 1 | 1/2 | 1 | 0,5 | 1/2 | 0 | $t_k^{max}/t_p$ | 16.6 | 48.6 | 64.7 | 88.9 |
| | | | | | | | | $w_k^{max}$ | 0.58 | 0.74 | -0.85 | -0.34 |
| | | | | | | | | $\Delta t_k^{1/2}/t_p$ | 17.7 | 13.6 | 12.7 | 14.4 |
| 10 | 2 | 2 | 1 | 4 | 0.71 | 1/2 | 0 | $t_k^{max}/t_p$ | 17.2 | 48.9 | 65.05 | 89.1 |
| | | | | | | | | $w_k^{max}$ | 0.59 | 0.72 | -0.88 | -0.34 |
| | | | | | | | | $\Delta t_k^{1/2}/t_p$ | 17.6 | 12.9 | 12.1 | 13.4 |
| 11 | 2 | 2 | 1 | 4 | 0.84 | 1/2 | 0 | $t_k^{max}/t_p$ | 17.7 | 49.2 | 65.3 | 89.2 |
| | | | | | | | | $w_k^{max}$ | 0.62 | 0.72 | -0.91 | -0.33 |
| | | | | | | | | $\Delta t_k^{1/2}/t_p$ | 17.2 | 12.9 | 11.9 | 13.9 |

## Patentansprüche

1. Verfahren zum Erzeugen eines Spektrums von Kernspinresonanz-Signalen durch Einstrahlen einer Sequenz von n HF-Impulsen auf eine Probe, die sich in einem homogenen statischen Magnetfeld befindet, wobei die Einhüllende der Kernspinresonanz-Signalantwort im Frequenzraum näherungsweise eine Rechteckfunktion ist,
dadurch gekennzeichnet,
daß $2 \leqq n \leqq 10$ gilt,
daß die n HF-Impulse der Sequenz amplituden-moduliert und ihre jeweiligen Amplitudenverteilungen annähernd der Form von Glockenkurven folgen, und daß vorab die Amplitudenverteilung der gesamten Impulssequenz in einer geeigneten Optimierungsprozedur unter dem Kriterium einer Minimierung der Abweichung der Einhüllenden der Kernspinresonanz-Signalantwort im Frequenzraum von einer Rechteckfunktion durch Variation von $3 \cdot n$ Parametern $w_k^{max}$, $t_k^{max}$, $a_k$ ermittelt worden ist, wobei $w_k^{max}$ die relative Amplitude des k-ten Impulses der Sequenz an der Position $t_k^{max}$ seines Extremums und $a_k$ die Breite des k-ten Impulses bedeuten.

2. Verfahren nach Anspruch 1, dadurch gekennzeichnet, daß die Minimierung der Abweichung der Einhüllenden der Kernspinresonanz-Signalantwort im Frequenzraum von einer Rechteckfunktion durch Anwendung eines numerischen Fitprogramms auf einer automatischen Datenverarbeitungsanlage erfolgt.

3. Verfahren nach Anspruch 1 oder 2, dadurch gekennzeichnet, daß die Minimierung der Abweichung der Einhüllenden der Kernspinresonanz-Signalantwort im Frequenzraum von einer Rechteckfunktion durch Optimieren eines vorgegebenen Fehlerfunktionals erfolgt, welches die Abweichung der Einhüllenden von einer Rechteckfunktion beschreibt.

4. Verfahren nach Anspruch 3, dadurch gekennzeichnet, daß der Abbruch der Optimierung erfolgt, wenn der Absolutwert des Fehlerfunktionals einen vorgegebenen Grenzwert unterschreitet.

5. Verfahren nach einem der Ansprüche 1 bis 4, dadurch gekennzeichnet, daß die Sequenz HF-Impulse enthält, deren Amplitudenverteilung der Form einer Lorentz-Kurve folgt.

6. Verfahren nach einem der Ansprüche 1 bis 4, dadurch gekennzeichnet, daß die Sequenz HF-Impulse enthält, deren Amplitudenverteilung der Form einer Gauß-Kurve folgt.

7. Verfahren nach einem der vorhergehenden Ansprüche dadurch gekennzeichnet, daß $n = 3$ gilt, und daß das Verfahren zur selektiven Inversion von kernmagnetischen Momenten verwendet wird.

8. Verfahren nach Anspruch 7, dadurch gekennzeichnet, daß die Parameter $w_k^{max}$, $t_k^{max}/t_p$ und $\Delta t_k^{1/2}/t_p$ jeweils einen entsprechenden Wert aus dem Intervall
$1,2 < w_2^{max}/w_1^{max} < 1,5$; $0,3 < w_3^{max}/w_1^{max} < 0,7$
$15 < \Delta t_1^{1/2}/t_p < 25$; $15 < \Delta t_2^{1/2}/t_p < 25$; $20 < \Delta t_3^{1/2}/t_p < 30$;
$20 < t_1^{max}/t_p < 40$; $40 < t_2^{max}/t_p < 60$; $70 < t_3^{max}/t_p < 90$
annehmen, wobei $\Delta t_k^{1/2}$ die halbe Impulsbreite des k-ten Impulses bei der halben Impulsamplitude $w_k^{max}/2$ und $t_p$ die zeitliche Dauer der Einhüllenden bedeutet und $a_k = \ln2/(\Delta t_k^{1/2})^2$.

9. Verfahren nach Anspruch 8, dadurch gekennzeichnet, daß die Parameter $w_k^{max}$, $t_k^{max}$ und $\Delta t_k^{1/2}/t_p$ jeweils den Wert
$w_1^{max} = -1,00$ ; $w_2^{max} = 1,37$ ; $w_3^{max} = 0,49$;
$\Delta t_1^{1/2}/t_p = 18,9$; $\Delta t_2^{1/2}/t_p = 18,3$; $\Delta t_3^{1/2}/t_p = 24,3$;
$t_1^{max}/t_p = 28,7$; $t_2^{max}/t_p = 50,8$; $t_3^{max}/t_p = 79,5$
annehmen.

10. Verfahren nach einem der Ansprüche 1 bis 6, dadurch gekennzeichnet, daß $n = 4$ gilt, und daß das Verfahren zur phasenrichtigen Anregung von transversaler Magnetisierung verwendet wird.

11. Verfahren nach Anspruch 10, dadurch gekennzeichnet, daß die Parameter $w_k^{max}$, $t_k^{max}/t_p$ and $\Delta t_k^{1/2}/t_p$ jeweils einen entsprechenden Wert aus dem Intervall
$0,95 < w_2^{max}/w_1^{max} < 1,35$; $-1,7 < w_3^{max}/w_1^{max} < -1,3$; $-0,7 < w_4^{max}/w_1^{max} < -0,4$;
$15 < \Delta t_1^{1/2}/t_p < 20$; $10 < \Delta t_2^{1/2}/t_p < 15$; $10 < \Delta t_3^{1/2}/t_p < 15$; $10 < \Delta t_4^{1/2}/t_p < 20$;
$5 < t_1^{max}/t_p < 25$; $40 < t_2^{max}/t_p < 60$; $55 < t_3^{max}/t_p < 75$; $75 < t_4^{max}/tp < 95$
annehmen, wobei $\Delta t_k^{1/2}$ die halbe Impulsbreite des k-ten Impulses bei der halben Impulsamplitude $w_k^{max}/2$ und $t_p$ die zeitliche Dauer der Einhüllenden bedeutet und $a_k = \ln2/(\Delta t_k^{1/2})^2$.

**12.** Verfahren nach Anspruch 11, dadurch gekennzeichnet, daß die Parameter $w_k^{max}$, $t_k^{max}$ und $\Delta t_k^{1/2}/t_p$ jeweils den Wert

$w_1^{max}= 0{,}62$ ; $w_2^{max}= 0{,}72$ ; $w_3^{max}= -0{,}91$; $w_4^{max}= -0{,}33$;

$\Delta t_1^{1/2}/t_p = 17{,}2$; $\Delta t_2^{1/2}/t_p = 12{,}9$; $\Delta t_3^{1/2}/t_p = 11{,}9$; $\Delta t_4^{1/2}/t_p = 13{,}9$;

$t_1^{max}/t_p = 17{,}7$; $t_2^{max}/t_p = 49{,}2$; $t_3^{max}/t_p = 65{,}3$; $t_4^{max}/t_p = 89{,}2$

annehmen.

**13.** Verfahren nach einem der vorhergehenden Ansprüche, dadurch gekennzeichnet, daß das Verfahren zur Erzeugung von Schnittbildern in der NMR-Tomographie verwendet wird.

**14.** Verfahren nach einem der Ansprüche 1 bis 12, dadurch gekennzeichnet, daß das Verfahren zur mehrdimensionalen NMR-Spektroskopie verwendet wird.

**15.** Verfahren nach Anspruch 14, dadurch gekennzeichnet, daß das Verfahren zur volumenselektiven NMR-Spektroskopie verwendet wird.

**16.** Verfahren nach Anspruch 14, dadurch gekennzeichnet, daß die Sequenz von n HF-Impulsen Teil einer NOESY-Impulsfolge ist.

**17.** Verfahren nach Anspruch 14, dadurch gekennzeichnet, daß die Sequenz von n HF-Impulsen Teil einer COSY-Impulsfolge ist.

**18.** Kernspinresonanz-Spektrometer mit einem HF-Impulsgenerator und einer Einrichtung zur Ansteuerung des HF-Impulsgenerators, die einen Speicher zur Speicherung von Datensätzen zur Erzeugung von HF-Impulssequenzen enthält, dadurch gekennzeichnet, daß der Speicher einen Datensatz zur Erzeugung einer Sequenz von amplituden-modulierten HF-Impulsen enthält, deren jeweilige Amplitudenverteilungen der Form von Glockenkurven folgen, und daß vorab die Amplitudenverteilung der gesamten Impulssequenz in einer geeigneten Optimierungsprozedur unter dem Kriterium einer Minimierung der Abweichung der Einhüllenden der Kernspinresonanz-Signalantwort im Frequenzraum von einer Rechteckfunktion durch Variation von $3 \cdot n$ Parametern $w_k^{max}$, $t_k^{max}$, $a_k$ ermittelt worden ist, wobei $w_k^{max}$ die relative Amplitude des k-ten Impulses der Sequenz an der Position $t_k^{max}$ seines Extremums und $a_k$ die Breite des k-ten Impulses bedeuten, und wobei $2 \leqq n \leqq 10$ gilt.

## Claims

**1.** Method for generating a spectrum of nuclear magnetic resonance signals by radiating a sequence of n RF pulses onto a sample which is located in a homogeneous static magnetic field, whereby the envelope of the nuclear magnetic resonance signal response in frequency space is approximately a rectangular function characterized in that

$$2 \leqq n \leqq 10,$$

in that the n RF pulses of the sequence are amplitude modulated and their respective amplitude distributions follow approximately the form of bell-shaped curves, and in that, in advance, the amplitude distribution of the entire pulse sequence is determined by means of a suitable optimization procedure with the criterion of a minimizing of the deviation of the envelope of the nuclear magnetic resonance signal response in frequency space from a rectangular function by variation of $3 \cdot n$ parameters $w_k^{max}$, $t_k^{max}$, $a_k$, whereby $w_k^{max}$ is the relative amplitude of the k-th pulse of the sequence at the position $t_k^{max}$ of an extremum and $a_k$ signifies the width of the k-th pulse.

**2.** Method according to claim 1, characterized in that the minimization of the deviation of the envelope of the nuclear magnetic resonance signal response in frequency space from a rectangular function is accomplished by use of a numerical fit program on an automatic data processing installation.

**3.** Method according to claim 1 or 2, characterized in that minimizing of the deviation of the envelope of the nuclear magnetic resonance response in the frequency space from a rectangular function is accomplished by optimization of a pre-determined error function, which describes the deviation of the envelope from a rectangular function.

**4.** Method according to claim 3, characterized in that the optimization is cut-off when the absolute value of the error function exceeds a predetermined limiting value.

5. Method according to one of the claims 1 to 4, characterized in that the sequence contains RF pulses whose amplitude distribution follows the shape of a Lorentz curve.

6. Method according to one of the claims 1 to 4, characterized in that the sequence contains RF pulses whose amplitude distribution follows the form of a Gaussian curve.

7. Method according to one of the preceding claims, characterized in that $n = 3$, and that the method is used for selective inversion of nuclear magnetic moments.

8. Method according to claim 7, characterized in that the parameters $w_k^{max}$, $t_k^{max}/t_p$ and $\Delta t_k^{1/2}/t_p$ take on in each case a corresponding value from the interval

$1.2 < w_2^{max} / w_1^{max} < 1.5$; $0.3 < w_3^{max} / w_1^{max} < 0.7$

$15 < \Delta t_1^{1/2}/t_p < 25$; $15 < \Delta t_2^{1/2}/t_p < 25$; $20 < \Delta t_3^{1/2}/t_p < 30$;

$20 < t_1^{max}/t_p < 40$; $40 < t_2^{max}/t_p < 60$; $70 < t_3^{max}/t_p < 90$

whereby $\Delta t_k^{1/2}$ is half the pulse width of the k-th pulse at the half pulse amplitude $w_k^{max}/2$ and $t_p$ represents the time duration of the envelope and $a_k = 1n2/(\Delta t_k^{1/2})^2$.

9. Method according to claim 8, characterized in that the parameters $w_k^{max}$, $t_k^{max}$ and $\Delta t_k^{1/2}/t_p$ take on in each case the value

$w_1^{max} = -1.00$; $w_2^{max} = 1.37$; $w_3^{max} = 0.49$;

$\Delta t_1^{1/2}/t_p = 18.9$; $\Delta t_2^{1/2}/t_p = 18.3$; $\Delta t_3^{1/2}/t_p = 24.3$;

$t_1^{max}/t_p = 28.7$; $t_2^{max}/t_p = 50.8$; $t_3^{max}/t_p = 79.5$.

10. Method according to one of the claims 1 to 6, characterized in that $n = 4$, and that the method is used for the in phase excitation of transverse magnetization.

11. Method according to claim 10, characterized in that the parameters $w_k^{max}$, $t_k^{max}/t_p$ and $\Delta t_k^{1/2}/t_p$ take on in each case a corresponding value from the interval

$0.95 < w_2^{max}/w_1^{max} < 1.35$; $-1.7 < w_3^{max}/w_1^{max} < -1.3$; $-0.7 < w_4^{max}/w_1^{max} < -0.4$;

$15 < \Delta t_1^{1/2}/t_p < 20$; $10 < \Delta t_2^{1/2}/t_p < 15$; $10 < \Delta t_3^{1/2}/t_p < 15$; $10 < \Delta t_4^{1/2}/t_p < 20$;

$5 < t_1^{max}/t_p < 25$; $40 < t_2^{max}/t_p < 60$; $55 < t_3^{max}/t_p < 75$; $75 < t_4^{max}/t_p < 95$

whereby $\Delta t_k^{1/2}$ signifies half the pulse width of the k-th pulse at the half pulse amplitude $w_k^{max}/2$ and $t_p$ represents the time duration of the envelope and $a_k = 1n2/(\Delta t_k^{1/2})^2$.

12. Method according to claim 11, characterized in that the parameters $w_k^{max}$, $t_k^{max}$ and $\Delta t_k^{1/2}/t_p$ take on in each case the value

$w_1^{max} = 0.62$; $w_2^{max} = 0.72$; $w_3^{max} = -0.91$; $w_4^{max} = 0.33$;

$\Delta t_1^{1/2}/t_p = 17.2$; $\Delta t_2^{1/2}/t_p = 12.9$; $\Delta t_3^{1/2}/t_p = 11.9$; $\Delta t_4^{1/2}/t_p = 13.9$;

$t_1^{max}/t_p = 17.7$; $t_2^{max}/t_p = 49.2$; $t_3^{max}/t_p = 65.3$; $t_4^{max}/t_p = 89.2$

13. Method according to one of the preceding claims, characterized in that the method is used for the generation of sectional images in NMR tomography.

14. Method according to any of claims 1 to 12, characterized in that the method is used for multidimensional NMR spectroscopy.

15. Method according to claim 14, characterized in that the method is used for volume selective NMR spectroscopy.

16. Method according to claim 14, characterized in that the sequence of n RF pulses is part of a NOESY pulse sequence.

17. Method according to claim 14, characterized in that the sequence of n RF pulses is part of a COSY pulse sequence.

18. Nuclear magnetic resonance spectrometer with an RF pulse generator and an arrangement for driving the RF pulse generator, which contains a memory for the storage of data sets for the generation of RF pulse sequences, characterized in that the memory contains a data set for the generation of a sequence of amplitude modulated RF pulses whose respective amplitude distributions follow the form of bell shaped curves, and that, in advance, the amplitude distribution of the entire pulse sequence has been determined in a suitable optimization procedure under the criterion of a minimization of the deviation of the envelope of the nuclear magnetic resonance signal response in frequency space from a rectangular function by variation of $3 \cdot n$ parameters $w_k^{max}$, $t_k^{max}$, $a_k$, whereby $w_k^{max}$ is the relative amplitude of the k-th pulse of the sequence at the position $t_k^{max}$ of its extremum and $a_k$ signifies the width of the k-th pulse, and whereby $2 \leqq n \leqq 10$.

## Revendications

1. Procédé pour l'engendrement d'un spectre de signaux de résonance magnétique nucléaire par radiation d'une séquence de n impulsions HF sur un échantillon, qui se trouve dans un champ magnétique statique homogène, où, l'enveloppe de la réponse de signal de résonance magnétique nucléaire, dans l'espace de fréquence, est approximativement une fonction rectangulaire,
   caractérisé en ce que $2 \leqq n \leqq 10$ est valable,
   que les n impulsions HF de la séquence modulée en amplitude et, chaque fois, leurs répartitions d'amplitudes suivent approximativement la formé de courbes en cloche, et que, avant tout, la répartition d'amplitudes de la séquence d'impulsion dans son ensemble a été déterminée, dans une procédure d'optimisation appropriée, avec le critère d'une minimalisation de la divergence de l'enveloppe de la réponse de signal de résonance magnétique nucléaire dans l'espace de fréquence d'une fonction rectangulaire, par variation de $3 \cdot n$ de paramètres n $w_k^{max}$, $t_k^{max}$ $a_k$, où, $w_k^{max}$ signifie l'amplitude relative de la kième impulsions de la séquence à la position $t_k^{max}$ de son extrémité, et $a_k$ signifie la largeur de la kième impulsion.

2. Procédé selon la revendication 1, caractérisé en ce que la minimisation des enveloppes de la réponse de signal de résonance magnétique nucléaire, dans l'espace de fréquence d'une fonction rectangulaire, a lieu par emploi d'un programme d'ajustement numérique sur une installation de traitement de données automatique.

3. Procédé selon la revendication 1 ou la revendication 2, caractérisé en ce que la minimisation de la divergence des enveloppes de la réponse de signal de résonance magnétique nucléaire, dans l'espace de fréquence d'une fonction rectangulaire, a lieu par optimisation d'une fonction d'erreur préallouée, laquelle décrit la divergence des enveloppes d'une fonction rectangulaire.

4. Procédé selon la revendication 3, caractérisé en ce que la rupture de l'optimisation a lieu, lorsque la valeur absolue de la fonction d'erreur franchit une valeur limite préallouée.

5. Procédé selon une des revendications 1 à 4, caractérisé en ce que la séquence contient des impulsions HF, dont la répartition d'amplitudes suit la forme d'une courbe de Lorentz.

6. Procédé selon une des revendications 1 à 4, caractérisé en ce que la séquence contient des impulsions HF, dont la répartition d'amplitudes suit la forme d'une courbe d'une courbe de Gauß.

7. Procédé selon une des précédentes revendications, caractérisé en ce que $n = 3$ est valable, et que le procédé est employé pour l'inversion sélective de moments magnétiques nucléaires.

8. Procédé selon la revendication 7, caractérisé en ce que les paramètres $w_k^{max}$, $t_k^{max}/t_p$ et $\Delta t_k^{1/2} t$, chaque fois, acceptent une valeur correspondante à partir de l'intervalle
   $1,2 < w_2^{max}/ w_1^{max} < 1,5$ ; $0,3 < w_3^{max}/ w_1^{max} < 0,7$
   $15 < \Delta t_1^{1/2}/t_p < 25$ ; $15 < \Delta t_2^{1/2}/t_p < 25$ ; $20 < \Delta t_3^{1/2}/t_p < 30$ ;
   $20 < t_1^{max}/t_p < 40$ ; $40 < t_2^{max}/t_p < 60$ ; $70 < t_3^{max}/t_p < 90$
   où $\Delta t_k^{1/2}$ signifie la moitié de la largeur d'impulsion de la kième impulsion, lors de la demi-amplitude d'impulsion $w_k^{max}/2$, et $t_p$ la durée temporaire des enveloppes, et $a_k = 1n2/( \Delta t_k^{1/2})^2$.

9. Procédé selon la revendication 8, caractérisé en ce que les paramètres $w_k^{max}$, $t_k^{max}$ et $\Delta t_k^{1/2}/t_p$, chaque fois, acceptent la valeur
   $w_1^{max} = -1,00$ ; $w_2^{max} = 1,37$ ; $w_3^{max} = 0,49$ ;
   $\Delta t_1^{1/2}/t_p = 18,9$ ; $\Delta t_2^{1/2}/t_p = 18,3$ ; $\Delta t_3^{1/2}/t_p = 24,3$ ;

**14**

$t_1{}^{max}/t_p = 28,7$ ; $t_2{}^{max}/t_p = 50,8$ : $t_3{}^{max}/t_p = 79,5$.

10. Procédé selon une des revendications 1 à 6, caractérisé en ce que n = 4 est valable, et que le procédé est employé pour l'activation, avec justesse de phase, de magnétisation transversale.

11. Procédé selon la revendication 10, caractérisé en ce que les paramètres $W_k{}^{max}$, $t_k{}^{max}/t_p$ et $\Delta t_k{}^{1/2}/t_p$, chaque fois, acceptent une valeur correspondante à partir de l'intervalle
$0,95 < w_2{}^{max}/w_1{}^{max} < 1,35$ ; $-1,7 < w_3{}^{max}/w_{1k}{}^{max} < -1,3$ ; $-0,7 < w_4{}^{max}/w_1{}^{max} < -0,4$ ;
$15 < \Delta t_1{}^{1/2}/t_p < 20$ ; $10 < \Delta t_2{}^{1/2}/t_p < 15$ ; $10 < \Delta t_3{}^{1/2}/t_p < 15$ ; $10 < \Delta t_4{}^{1/2}/t_p < 20$ ;
$5 < t_1{}^{max}/t_p < 25$ ; $40 < t_2{}^{max}/t_p < 60$ ; $55 < t_3{}^{max}/t_p < 75$ ; $75 < t_4{}^{max}/t_p < 95$,
où, $\Delta t_k{}^{1/2}$ signifie la moitié de la largeur d'impulsion de la kième impulsion, lors de la demi-amplitude d'impulsion $w_k{}^{max}/2$, et $t_p$ la durée temporaire des enveloppes, et $a_k = 1n2/(\Delta t_k{}^{1/2}/)^2$.

12. Procédé selon la revendication 11, caractérisé en ce que les paramètres $w_k{}^{max}$, $t_k{}^{max}$ et $\Delta t_k{}^{1/2}/t_p$, chaque fois, acceptent la valeur
$w_1{}^{max} = 0,62$ ; $w_2{}^{max} = 0,72$ ; $w_3{}^{max} = -0,91$ ; $w_4{}^{max} = -0,33$ ;
$\Delta t_1{}^{1/2}/t_p = 17,2$ ; $\Delta t_2{}^{1/2}/t_p = 12,9$ ; $\Delta t_3{}^{1/2}/t_p = 11,9$ ; $\Delta t_4{}^{1/2}/t_p = 13,9$;
$t_1{}^{max}/t_p = 17,7$ ; $t_2{}^{max}/t_p = 49,2$ ; $t_3{}^{max}/t_p = 65,3$ ; $t_4{}^{max}/t_p = 89,2$.

13. Procédé selon une des précédentes revendications, caractérisé en ce que le procédé est employé pour l'engrendrement d'images de coupe dans la tomographie RMN (résonance magnétique nucléaire).

14. Procédé selon une des revendications 1 à 12, caractérisé en ce que le procédé est employé pour la spectroscopie RMN pluridimensionnelle.

15. Procédé selon la revendication 14, caractérisé en ce que le procédé est employé pour la spectroscopie RMN à sélection de volumes.

16. Procédé selon la revendication 14, caractérisé en ce que la séquence de n impulsions HF est une partie d'une suite d'impulsions NOESY.

17. Procédé selon la revendication 14, caractérisé en ce que la séquence de n impulsions HF est une partie d'une suite d'impulsions COSY.

18. Spectromètre pour résonance magnétique nucléaire, avec un générateur d'impulsions HF et un agencement pour la commande du générateur d'impulsions HF, qui contient une mémoire pour la mise en mémoire de blocs de données pour l'engendrement de séquences d'impulsions HF, caractérisé en ce que la mémoire contient un bloc de données pour l'engendrement d'une séquence d'impulsions HF modulées en amplitude, dont les répartitions d'amplitudes suivent, chaque fois, la forme de courbes en cloche, et que, préalablement, la répartition d'amplitudes de l'ensemble de la séquence d'impulsions a été déterminée, dans une procédure d'optimisation appropriée, avec le critère d'une minimalisation de la divergence des enveloppes de la réponse de signal de résonance magnétique nucléaire, dans l'espace de fréquence d'une fonction rectangulaire, par variation de $3 \cdot n$ de paramètres n $w_k{}^{max}$, $t_k{}^{max}$, $a_k$, où, $w_k{}^{max}$ signifie l'amplitude relative de la kième impulsion de la séquence, à la position $t_k{}^{max}$ de son extrémité, et $a_k$ signifie la largeur de la kième impulsion, et, où, $2 \leqq n \leqq 10$ est valable.

Fig.1

Fig. 2

EP 0 502 850 B1

Fig. 3

EP 0 502 850 B1

Fig. 4

a)

$\Omega/\omega_1{}^{max}$

b)

$\Omega/\omega_1{}^{max}$

Fig. 5

Fig. 6